Europäisches Patentamt

European Patent Office

Office européen des brevets

(11) Publication number: **0 332 723**
**A1**

## (12) EUROPEAN PATENT APPLICATION

(21) Application number: **88104096.8**

(22) Date of filing: **15.03.88**

(51) Int. Cl.4: **H01S 3/19 , H01S 3/08**

(43) Date of publication of application:
**20.09.89 Bulletin 89/38**

(84) Designated Contracting States:
**DE FR GB IT**

(71) Applicant: **International Business Machines Corporation**
**Old Orchard Road**
**Armonk, N.Y. 10504(US)**

(72) Inventor: **Bächtold, Werner**
**Erlenweg 4**
**CH-8135 Langnau a. Albis(CH)**
Inventor: **Broom, Ronald F.**
**Hügelstrasse 16**
**CH-8002 Zürich(CH)**
Inventor: **Harder, Stephan Christoph**
**Renggerstrasse 66**
**CH-8038 Zürich(CH)**
Inventor: **Jäckel, Heinz**
**Vorbühlstrasse 27**
**CH-8802 Kilchberg(CH)**
Inventor: **Meier, Peter Heinz**
**Langrütistrasse 1**
**CH-8800 Thalwil(CH)**
Inventor: **Walter, Willi**
**Baumgartenweg 2**
**CH-8134 Adliswil(CH)**

(74) Representative: **Schröder, Otto H., Dr. Ing. et al**
**IBM Corporation Säumerstrasse 4**
**CH-8803 Rüschlikon(CH)**

(54) **High-power semiconductor diode laser.**

(57) The segmented waveguide diode laser structure has non-absorbing mirror sections (14M) that allow high power output without facet damage. Light generated in the active laser section (12A) is coupled into the mirror sections (14 M) where it is fully guided when propagating towards the reflecting mirror facets (18).

In one embodiment, the laser structure is formed on a patterned substrate (10) having planar mesa- (10A) and groove- (10M) sections, with sloped transition zones (10T) inbetween. It comprises an active (WG1) and a passive (WG2) waveguide. These are vertically stacked, parallel to the substrate surface, and separated from each other by a cladding layer(13). The gain segment (12A) of the active waveguide (WG1) is aligned with the non-absorbing mirror sections (14M) of the passive waveguide (WG2).

# FIG. 1

# HIGH-POWER SEMICONDUCTOR DIODE LASER

The invention concerns a high-power semiconductor laser comprising an active optical waveguide and, coupled thereto, non-absorbing mirror sections that extend to the reflecting mirror facets of the laser structure.

Semiconductor diode lasers have found applications in a wide variety of information handling systems because of their compact size and because their technology is compatible with that of the associated electronic circuitry. For a number of applications, such as optical storage and laser-beam printing, lasers capable of high optical output powers are in demand. However, devices consisting of GaAs, today the most commonly used material in semiconductor lasers, are generally limited to moderate output powers since, at high power emission, the absorption of laser radiation at the semiconductor/air interfaces causes a sudden heat up of the mirror regions. This leads to the destruction of the device. This effect is often referred to as catastrophic optical mirror damage (COMD).

Various laser structures have been proposed aiming at solutions that overcome this problem. Most promising appear to be structures with passive mirror sections. In such devices only the mirror sections, normally consisting of AlGaAs, and not the active light emitting layer, normally of GaAs, extend to the laser mirror facet. COMD is avoided since the mirror sections are non-absorbing. In the literature, these structures are referred to as non-absorbing mirror (NAM) structures. "Window structure" is another term that is often used. The underlying common principle of these devices can be seen in that the light is generated in a central low energy gap active region having higher gap window regions arranged at both ends to which the light is coupled and from where the laser beam is emitted.

Typical for the present state of the art are the structures described in the following publications :
- Article by T.Yagi et al "AlGaAs Self-Aligned Bent Active Layer Laser Diode with Self-Aligned Window Structure" (Proc.IEEE Int.Semiconductor Laser Conf. Kanazawa, Japan 1986, pp. 10-11).
The authors disclose a window-type laser : The layered structure, comprising the active layer embedded between cladding layers topped with a contact layer, is deposited on an U-grooved substrate. The active layer curves like a U whereas the contact layer takes a V-shape - the V-groove determining the cleaving point. In the final laser structure, the active layer is bent near the mirror facets. The laser beam, not following the bend, is emitted through the upper cladding layer. For beams of sufficient quality, the length of the NAM section in which the beam propagates unguided needs to be short and accurately defined. Cleaving with 1 $\mu$m accuracy is required.
- Article by J.Ungar et al "High-Power GaAlAs Window Lasers" (Electr. Letters, Vol.22, No.5, 1986, pp. 279-280).
Another window-type structure is described in which an additional large optical cavity layer is provided between the active and the lower cladding layer. The additional layer has a thickness greater than that of the active stripe. By appropriately choosing the refractive indices, most of the power propagates in the additional layer and in the non-absorbing adjacent cladding layer and continues to the facet without interruption. The structure becomes quite complex and requires the use of Liquid-Phase Epitaxy (LPE) growth methods.
- Article by T.Murakami et al "A Very Narrow Beam AlGaAs Laser with a Thin Tapered-Thickness Active Layer" (Proc.IEEE Int. Semiconductor Conf. Kanazawa, Japan 1986, pp.76-77).
This article shows a layered structure deposited on a substrate with a ridge pattern surface. The width of the ridge is narrower near the mirror than in the active region. LPE growth on such a structure results in a tapered-thickness active layer. In the thin mirror sections, a quantum-size effect is expected, which can be utilized to form a window structure laser. The structure requires the use of LPE processes and the achievable output power appears to be limited.

Still further proposals for high-power laser structures have been disclosed in
- Article by T.Ohtoshi et al "High-Power visible GaAlAs Lasers with Self-Aligned Strip Buried Heterostructure" (J.Appl.Phys. 56, Nov.1984, pp.2491-2495);
- Article by H.Blauvelt et al "Large Optical Cavity AlGaAs Buried Heterostructure Window Lasers" (Appl.Phys.Lett. 40, June 1982, pp.1029-1031)
- Article by H.Yonezu et al "High Optical Power Density Emission from a 'Window-Stripe' AlGaAs Double-Heterostructure Laser" (Appl.Phys.Lett. 34, May 1979, pp.637-639).

A common problem generally encountered with the known NAM structures is that the mirror sections need to be very short and accurately defined in order to avoid beam distortions. The structures are thus difficult to fabricate.

It is the main object of the present invention to provide a high-power semiconductor laser having non-absorbing mirror sections, the structure being of a relatively simple design and allowing fabrication tolerances that can be achieved with modern growth processes such as Molecular Beam Epitaxy (MBE), Chemical Beam Epitaxy (CBE), or Metal Organic Chemical Vapor Deposition (MOCVD).

The invention as claimed is intended to meet this and other objectives and to remedy the drawbacks and deficiencies of known laser devices. It solves the problems hitherto encountered in the design of NAM structures by providing, in the mirror section, a passive waveguide for guiding the beam, generated in the active section of the device, to the mirror facets.

The advantages offered by the invention are mainly that the guided mode propagation through the mirror section allows long NAM-regions and thus uncritical mirror cleaving processes, and that beam parameters such as facet spot size and beam divergence can be optimized by changing the parameters of the mirror waveguide independent from, and therefore not affecting, the design of the central gain section. The diffraction losses in the NAM sections are substantially lower than in known mirror structures with unguided mode propagation.

The invention is described in detail below with reference to drawings which illustrate the underlying principles and a specific embodiment of the invention, and in which

Fig.1 is a schematic illustration of the basic structure and elements of the inventive semiconductor diode laser.

Fig.2 shows, quantitatively, the modes of both, the active and the passive waveguide, and the residual undesired coupling in the inventive laser structure.

Fig.3 illustrates the diffraction loss mechanism in the transition zone of the inventive laser structure in which the generated beam couples longitudinally into the passive wave guide of the mirror sections.

Fig.4 is a schematic illustration of an embodiment of of the inventive laser in which a QW GRINSCH structure serves as the active waveguide of the device.

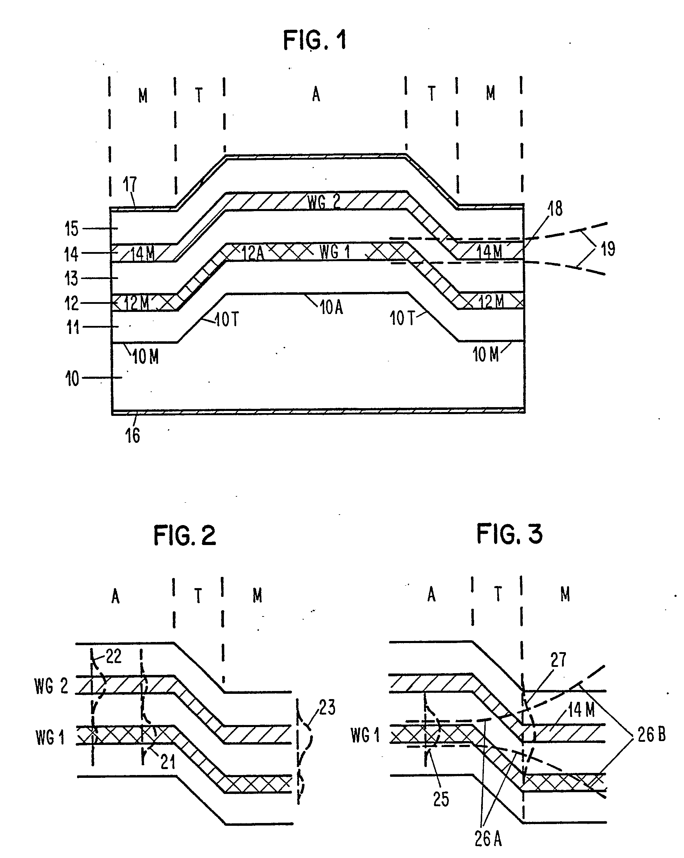

The basic concept on which the invention is based will now be described with the aid of Fig.1. The figure shows the basic structure of the inventive semiconductor diode laser. It consists of a stack of semiconductor layers 11 to 15 grown on the surface of a substrate 10.

Substrate 10 and layer 11 are of a first conductivity type, e.g. n-type, layers 12 to 15 are of a second conductivity type, e.g. p-type. The interface between layers 11 and 12 provides the p-n junction of the diode laser. Radiative transitions and laser action occurs in the junction region, in the described structure in the thin layer 12. This layer, embedded between cladding layers 11 and 13, serves as active waveguide WG1 that is defined by heterojunctions at the interfaces with the cladding layers. Layer 14, embedded between cladding layers 13 and 15, provides a passive wave guide WG2.

Ohmic contacts 16 and 17 are connected to the substrate 10 and to upper cladding layer 15, respectively. They allow the application of a forward bias voltage which causes the current flow through the p-n junction required for laser action.

The layered structure is grown on the surface of substrate 10 which is patterned as shown : the surface comprises a planar mesa section 10A and, at both sides thereof, planar groove sections 10M, with slanted transition zones 10T inbetween. In the figures, the corresponding segments of the layered laser structure are designated A, M and T, respectively.

Waveguide WG1 is designed as the active layer. The waveguide is defined by the cladding layers 11 and 13 consisting of semiconductor material having a higher band gap than that of layer 12. With a forward bias voltage applied, low threshold radiative recombination of holes and electrons occurs thereby generating a light beam parallel to the plane of the layers of the structure and optically and electrically confined in the waveguide. Lateral confinement can be achieved, applying known techniques, by narrowing the active region through the use of proper etching techniques.

Layer 14 and its adjacent cladding layers 13 and 15 are designed to form a passive waveguide WG2, having no active region, by choosing the materials and dimensions such that no absorption of the laser radiation takes place, e.g., by increasing the Al-content.

As can be seen in Fig.1, the vertical displacements between layers 12 and 14, i.e., the active and the passive waveguides, and between the planar mesa- and groove-surfaces 10A and 10M, respectively, are such that the gain segment 12A of the active waveguide WG1 above mesa surface 10A is in alignment with the segments 14M of the passive waveguide WG2 above groove surface section 10M.

In operation, a foreward bias voltage is applied to ohmic contacts 16 and 17. When the magnitude of the resulting current through the p-n junction equals at least the value of the threshold current, light is generated in gain section 12A of the active waveguide WG1. Due to the alignment of this section with sections 14M of the passive waveguide WG2, the light beam is efficiently coupled, through the slanted portions of cladding layer 13, into sections 14M. These serve as non absorbing mirror sections. At both ends, the optical laser cavity resonator comprising segments 14M-12A-14M is defined by reflecting mirror facets 18 perpendicular to the layer plane. The high reflectivity of the semiconductor/air interface provides optical feedback into the cavity so that, when the injected current is equal to or higher than the threshold current, round-trip optical gain is achieved, sufficient to overcome losses, and laser action results. A laser beam 19 is emitted.

As stated above, the laser cavity comprises segments 14M-12A-14M. Because waveguide WG2, and thus segments 14M, is non-absorbing, a laser with non-absorbing mirrors (NAM) is provided. Due to the structured substrate, the potentially absorbing sections 12M of waveguide WG1 are removed from the beam radiation pattern and play no role in the laser operation.

Contrary to known NAM laser structures, the beam is well guided in the mirror sections 14M. This allows long NAM sections, their length and thus the cleaving process are not critical. In structures with unguided NAM mirror sections the diffraction is detrimental to beam quality when the NAM section is longer than about 5 $\mu$m..

In order to avoid far-field distortion and gain-loss, it is necessary to keep the coupling between the gain region of waveguide WG1 and passive waveguide WG2 as low as possible. This can be achieved by designing the two waveguides non-identical to break the symmetry of the structure and/or by making the separating cladding layer 13 sufficiently thick. A separation of of 1 $\mu$m is sufficient for efficient decoupling.

Fig.2 illustrates quantitatively the pattern of mode 1 (curve 21) and mode 2 (curve 22) of waveguides WG1 abd WG2, respectively, i.e., it shows the energy distribution of the radiation. It is close to the pattern of completely uncoupled waveguides. The effect of residual parasitic coupling is indicated by the small bumps in the wings of the respective modes. Curve 23 represents the energy distribution of the outgoing light beam.

Fig.3 illustrates the diffraction loss mechanism in the transition region T as mode 1 (curve 25) couples longitudinally from WG1 into the guided mirror section 14M. Diffraction spreading of mode 1 occurs in the transition region where the beam is vertically unguided. Simulations have shown that, since the transition regions can be kept very short (about 1 to 2 $\mu$m), the power coupling coefficient is around 0.99, i.e., diffraction losses are minimal for realistic dimensions. The structure can be optimized by modifying e.g. the thickness of layer 14 without changing the dimensions or parameters of the active cavity section of WG1.

Fig.3 also demonstrates the important advantage offered by the use of mirror sections in which the beam is guided. In the described structure, diffraction (indicated by the outward bent curve 26A) only takes place in the transition zone and results in only a small change in the beam energy distribution (curve 27). In segment M, the beam is again guided in the mirror section 14M of WG2. In hitherto known structures, the diffraction continues in the unguided mirror section as illustrated by curve 26B causing severe energy loss and beam quality problems unless the mirror section is kept extremely short.

Calculations for realistic structures, i.e., structures with proper choice of materials, have shown that parasitic reflections at the bend of the layers in the transition region T are also minimal because the difference in refractive index of the materials of layers 12 and 14 are in the order of a few percent only.

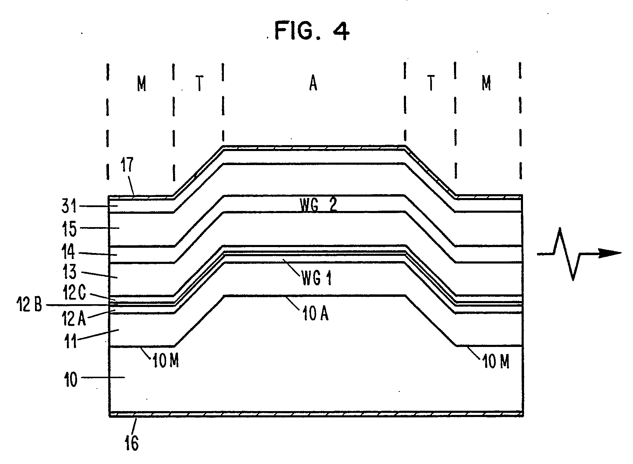

A specific embodiment of the inventive laser, based on GaAs technology and designed in accordance with the principles described above, is shown in Fig.4. Where appropriate, the same reference numbers have been used for corresponding structural elements as in Fig.1.

The substrate 10 consists of n + GaAs, the surface is structured as shown in the figure. The vertical displacement between planar mesa (10A) and groove (10M) regions is 1.5 $\mu$m. The slope in the transition region T being about 35°, the longitudinal extension of the transition zone is about 2 $\mu$m. The width of the mesa region, which determines the length of the gain region of the completed laser structure, is about 200 to 500 $\mu$m. The length of sections 10M that determines the length of the mirror segments is in the order of 20 $\mu$m, the maximum length depending on the residual absorption.

Structured substrate surfaces and processes for their fabrication are well known and will not be described in detail herein. The mesa-groove pattern on which the layered structure of the inventive laser is grown can, for example, be obtained on a (100) crystal surface with an isotropic wet-etch process using a HF-solution as etchant. The slope in the transition zone between mesa and groove will then be about 35°. The etch time determines the depth of the groove which can be predetermined with an accuracy of about +/- 10 nm.

The stack of semiconductor layers is grown on the structured substrate surface using an MBE process; alternatively, a CBE or a MOCVD technique may also be employed.

In the embodiment herein described, the active waveguide WG1 serves as the waveguide of an AlGaAs Quantum Well (QW) GRIN-SCH laser (Graded Refractive Index - Separate Confinement Heterostructure), i.e., a light emitting semiconductor laser with one or more quantum wells in its active region. The QWs have a bandgap narrower than the surrounding cladding material and a thickness comparable to the Broglie wavelength. In the GRIN-SCH structure, the Al-content, and thus the refractive index, in the material next to the active GaAs layer is gradually changed whereby electrical and optical confinement in the waveguide can be optimized independent from each other.

The complete stack of semiconductor layers grown on the substrate 10 comprises :

| - lower cladding layer 11 | of n-$Al_x$ $Ga_{1-x}$ As (with x = 0.3), 1.5 $\mu$m thick; |
|---|---|
| - GRIN-SCH structure comprising | |
| graded layer 12A | of n-$Al_x$ $Ga_{1-x}$ As (x = 0.18-0.35),200 nm thick; |
| undoped QW layer 12B | of i-GaAs,10 nm thick; |
| graded layer 12C | of p-$Al_x$ $Ga_{1-x}$ As (x = 0.18-0,35),200 nm thick; |
| - sep. cladding layer 13 | of p-$Al_x$ $Ga_{1-x}$ As (with x = 0.35), 1 $\mu$m thick; |
| - passive waveguide layer 14 (parabolically graded) | of p-$Al_x$ $Ga_{1-x}$ As (x = 0.35-0.25-0.35), 0.6 $\mu$m thick; |
| - upper cladding layer 15 | of p-$Al_x$ $Ga_{1-x}$ As (with x = 0.35),1.5 $\mu$m thick; |
| - contact layer 31 | of p + GaAs, 0.03 $\mu$m thick. |

The ohmic contacts 16 and 17 consist of Au(Ni,Ge) and Au(Ti,Pt), respectively.

In the completed device, the lateral width (perpendicular to the plane of the drawing) of the active waveguide is about 5 $\mu$m.

As has been explained above, gain section 12A and mirror sections 14M need to be aligned. This is achieved provided the vertical displacement between mesa (10A) and groove (10M) planes of the substrate surface equals the vertical distance between the center lines of the two waveguides WG1 and WG2. The condition for the thicknesses of layers 12, 13 and 14 can thus be written :

mesa-groove displacement = d(13) + 1/2 d(12) + 1/2(14)

This is fulfilled with the dimensions chosen in the described embodiment where the mesa-groove displacement equals 1.5 $\mu$m and where d(13) = 1.0 $\mu$m, d(12) = 0.4 $\mu$m, and d(14) = 0.6 $\mu$m.

The thickness of layers grown using MBE, CBE or MOCVD processes can be controlled with about the same accuracy as that of the processes used to etch the grooves, i.e., +/- 10 nm. This accuracy is generally sufficient for the fabrication of the new laser structure. As explained above, beam quality can be optimized, if necessary, by slight modifications of the WG2 mirror sections. The beam may, e.g., be expanded.

The fact that the structure has two waveguides offers an important advantage. It allows the active one (WG1) to be optimized for gain whereas the passive waveguide (WG2) can be optimized for beam quality independently.

The embodiment that has been described in detail is based on GaAs/AlGaAs technology which offers the important advantage that GaAs and AlGaAs lattices match thereby avoiding stress, absorbing surface states, and other problems that result from lattice mismatch. The basic concepts of (1) wave-guiding in the non-absorbing mirror sections, and (2) alignment of the gain segment of the active waveguide with a passive waveguide forming the NAM mirror sections, can however also be applied to different material systems such as other III/V compounds or even II/VI-systems.

Without departing from the spirit of the invention, other changes in structure and materials may be made. The QW-GRIN-SCH structure may, e.g. be replaced by an "ordinary" double-hetero structure; the gain section of the active waveguide may be arranged above a groove of the substrate surface rather then above the mesa, etc. Also, the laser structure may be fabricated using other growth techniques suitable for accurate growth or deposition of the required semiconductor layers.

## Claims

1. High-power semiconductor diode laser comprising an active optical waveguide (WG1) and, coupled to said active waveguide, non-absorbing mirror sections (14M) extending to reflecting mirror facets (18) of the laser structure,

characterized in that

said mirror sections comprise segments (14M) of a passive optical waveguide (WG2) that are aligned with said active optical waveguide (WG1) such that a light beam generated in the active waveguide is longitudinally coupled into said passive waveguide sections where the beam is fully guided when propagating towards said reflecting mirror facets (18).

2. A diode laser as in claim 1, wherein said active waveguide (WG1) is separated from said segments (14M) of the passive waveguide by a layer (13) consisting of a material having electrical and optical characteristics different from those of the active waveguide and through which said longitudinal coupling occurs.

3. A diode laser as in claim 1, wherein
- the laser structure is formed in a stack of semiconductor layers (11 to 15) that are deposited on a patterned surface of a semiconductor substrate (10),
- said patterned surface exhibits planar mesa (10A) and groove (10M) sections, vertically displaced with respect to each other and with sloped transition zones (10T) inbetween,
- said stack of semiconductor layers further comprising said passive optical waveguide (WG2) which is separated from said active waveguide (WG1) by a cladding layer (13),
- said vertical displacement between said mesa (10A) and groove (10M) sections and the thickness of the cladding layer (13) which separates the active (WG1) and the passive (WG2) waveguide are chosen such that the segment (12A) of the active waveguide which is formed above a first of said planar surface sections (10A) is in alignment with those segments (14M) of the passive waveguide which are formed above those planar surface sections (10M) that are vertically displaced from and adjacent to said first planar surface section (10A), and in that
- the reflecting mirror facets (18) terminating the waveguides are essentially perpendicular to the plane of the waveguides,
whereby the segment (12A) of the active waveguide above said first planar surface section forms the optical cavity of the diode laser whereas the aligned segments of the passive waveguide form non-absorbing mirror sections (14M).

4. A diode laser as in claim 1,2 or 3, wherein the structure is composed of GaAs/AlGaAs layers.

5. A diode laser as in claim 1, 2 or 3, wherein said active optical waveguide (WG1), is formed by a Graded Refractive Index - Separate Confinement Heterostructure (GRIN-SCH).

6. A diode laser as in claim 1, 2 or 3, wherein said active optical waveguide (WG1) is formed by a Double-Heterostructure (DH).

7. A diode laser as in claim 3, wherein the segment (12A) of the active waveguide (WG1) that provides the optical cavity is formed above said planar mesa section (10A) of the patterned surface.

8. A diode laser as in claim 3, wherein the segment of the active waveguide that provides the optical cavity is formed above said planar groove sections (10M) of the patterned surface.

9. A diode laser as in claim 1, wherein the structure is formed in a narrow groove provided in the surface of a supporting substrate and extending in the direction of the light beam, the walls of the groove providing for lateral confinement.

10. A diode laser as in claim 1, wherein the structure has the shape of a narrow ridge extending in the direction of the light beam, the small width of the ridge providing for lateral confinement.

# FIG. 1

M    T        A        T    M

17

WG 2

15

14    14M    12A    WG 1    14M    18

13                                19

12    12M    10A    12M

11    10T    10T

10M    10M

10

16

# FIG. 2

A    T    M

22

WG 2

23

WG 1

21

# FIG. 3

A    T    M

27

14M

WG 1    26 B

25

26 A

IBM SZ 9 – 87 – 010

## FIG. 4

# EUROPEAN SEARCH REPORT

Application Number

EP 88 10 4096

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 069 563 (HITACHI LTD) * Page 2, line 13 - page 4, line 9; page 5, line 10 - page 8, line 5; page 10, line 13 - page 11, line 21; page 14, line 8 - page 15, line 10; figures 2,3,5,6,11 * | 1,2,4,6 | H 01 S 3/19 H 01 S 3/08 |
| A | --- | 3,7,8 | |
| Y | DE-A-3 604 294 (TELEFUNKEN ELECTRONIC GmbH) * Column 2, lines 17-50; column 3, lines 1-64; figures 2,3 * | 1 | |
| A | --- | 2-4,6-8 | |
| Y | JP-A-63 034 993 (NEC CORP.)(15-02-1988) & PATENT ABSTRACTS OF JAPAN, vol. 12, no. 246 (E-632)[3093], 12th July 1988, abstract | 1 | |
| A | --- | 3,4,6-8 | |
| A | DE-A-3 604 293 (TELEFUNKEN ELECTRONIC GmbH) * Column 4, line 28 - column 5, line 31; figures 7b,8b * | 1-4,6-8 | TECHNICAL FIELDS SEARCHED (Int. Cl.4) H 01 S |
| A | --- PATENT ABSTRACTS OF JAPAN, vol. 9, no. 165 (E-327)[1888], 10th July 1985; & JP-A-60 41 279 (HITACHI SEISAKUSHO K.K.) 04-03-1985 * Abstract * --- -/- | 1,3,4,7 ,8 | |

The present search report has been drawn up for all claims

| Place of search | Date of completion of the search | Examiner |
|---|---|---|
| THE HAGUE | 08-11-1988 | GNUGESSER H.M. |

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | XEROX DISCLOSURE JOURNAL, vol. 4, no. 5, September/October 1979, page 637; R.D. BURNHAM et al.: "Prevention of optical facet damage in semiconductor lasers" * Whole document * | 1,3 | |

TECHNICAL FIELDS
SEARCHED (Int. Cl.4)

The present search report has been drawn up for all claims

| Place of search | Date of completion of the search | Examiner |
|---|---|---|
| THE HAGUE | 08-11-1988 | GNUGESSER H.M. |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons
 
& : member of the same patent family, corresponding
     document

EPO FORM 1503 03.82 (P0401)